# FASCICULE DE BREVET EUROPEEN

(11) **EP 1 446 877 B1**
(45) Date de publication et mention de la délivrance du brevet: **23.05.2012**
(21) Numéro de dépôt: 02777304.3
(22) Date de dépôt: 10.10.2002
(51) Int. Cl.: H03K 17/96, G01V 3/08

(54) **BOITIER DESTINE A CONTENIR UN CAPTEUR CAPACITIF ET POIGNEE D'OUVRANT DE VEHICULE AUTOMOBILE**
GEHÄUSE FÜR EINEN KAPAZITIVEN SENSOR UND TÜRGRIFF EINES KRAFTFAHRZEUGES
CASING INTENDED TO HOUSE A CAPACITIVE SENSOR AND AN OPENING HANDLE FOR A MOTOR VEHICLE

(30) Priorité: 11.10.2001 FR 0113109
(43) Date de publication de la demande: 18.08.2004
(73) Titulaire: Valeo Sécurité Habitacle S.A.S., 94042 Créteil cedex (FR)
(72) Inventeur: HUTH, Jean-Claude, F-92160 Antony (FR); MUSAT, Ciprian, F-94000 Créteil (FR)
(74) Mandataire: Jacquot, Ludovic R. G.
(86) Numéro de dépôt international: PCT/EP2002/011377
(87) Numéro de publication internationale: WO 2003/034591

(56) Documents cités:
- WO-A-00/42628
- WO-A-01/40606
- DE-A- 10 007 500
- DE-A- 10 100 972
- US-A- 4 380 040
- US-A- 5 063 306
- CHEN Z ET AL: "DESIGN AND IMPLEMENTATION OF CAPACITIVE PROXIMITY SENSOR USING MICROELECTROMECHANICAL SYSTEMS TECHNOLOGY" IEEE TRANSACTIONS ON INDUSTRIAL ELECTRONICS, IEEE INC. NEW YORK, US, vol. 45, no. 6, 1 décembre 1998 (1998-12-01), pages 886-894, XP000789099 ISSN: 0278-0046

## Description

La présente invention concerne un boîtier comprenant un capteur capacitif et une poignée d'ouvrant de véhicule automobile.

On sait que les capteurs capacitifs sont des dispositifs qui mesurent des variations de champ électrique dans leur environnement. En général, Ils sont conçus et réglés pour avoir un "champ de vision", c'est-à-dire un volume de détection, limité afin de déceler de manière fiable l'approche d'un objet dans leur voisinage.

Les capteurs capacitifs connaissent différentes applications.

Ils sont en général intégrés dans des boîtiers de protection.

Ainsi, un capteur "volt" les modifications de champ électrique dans un volume donné à travers la paroi extérieure du boîtier. Ce volume délimite, sur la paroi extérieure du boîtier, une zone de détection qui joue le même rôle qu'un bouton sur lequel un utilisateur viendrait appliquer un doigt pour déclencher une action.

La zone de détection se distingue cependant d'un simple bouton par le fait qu'elle peut réagir à un contact, on parle alors de zone tactile, ou à une simple approche, on parle alors de zone d'approche. Dans cette application, la réalisation d'une zone d'approche ou d'une zone tactile dépend de la sensibilité du capteur capacitif utilisé.

Une application particulière de tels capteurs capacitifs concerne les poignées d'ouvrants de véhicules automobiles, pour lesquelles on gère de manière électronique les systèmes de verrouillage et de déverrouillage centralisés des portières ainsi que les conditions d'accès sans clef au véhicule. De tels systèmes sont également désignés "systèmes d'accès mains libres". Un exemple de réalisation de tels systèmes est donné dans le document DE 100 07 500.

Dans de tels systèmes, la commande du déverrouillage du véhicule utilise un capteur capacitif, auquel est associé une zone d'approche, pour détecter la présence ou l'approche de l'utilisateur au niveau de la poignée. Cette détection d'approche permet d'initier la communication entre l'Identifiant porté par l'utilisateur et le système embarqué dans le véhicule pour identifler l'utilisateur et autoriser ou non son accès au véhicule.

Pour le verrouillage du véhicule, on utilise un second capteur capacitif, de sensibilité moins importante que celui utilisé pour la détection d'approche, auquel est associé une zone tactile, pour la détection tactile d'une action volontaire de l'utilisateur au niveau de la poignée en vue du verrouillage du véhicule.

Une difficulté liée aux capteurs capacitifs est que leurs boîtiers ne doivent pas présenter de conductivité électrique, sous peine de dégrader très fortement leur fiabilité.

Cette difficulté constitue une limitation notamment lorsqu'il s'agit de réaliser des poignées de portières de véhicules automobiles car les rendus esthétiques souhaités par les constructeurs, par exemple sous la forme de chromages ou de peintures, apportent des éléments conducteurs perturbateurs sur le boîtier qui nuisent au bon fonctionnement des différents capteurs capacitifs présents.

En particulier dans le cas des poignées de véhicules automobiles présentant une surface peinte, il est apparu des cas de non-détection de l'approche et de l'action volontaire de l'utilisateur au niveau de la poignée.

Ces dysfonctionnements des capteurs capacitifs pour la détection d'approche et la détection tactile sont dus à la présence de particules métalliques au niveau de la surface peinte de la poignée. Ces particules métalliques entrent généralement dans la composition de la peinture ou sont présentes dans l'apprêt nécessaire à l'application de la peinture sur la surface de la poignée. Ces particules ou éléments conducteurs présentent des propriétés de conduction électrique de sorte qu'une fois appliquée sur un substrat telle qu'une poignée, la peinture forme une nappe électriquement conductrice qui nuit au bon fonctionnement des différents capteurs dont les zones de détection se trouvent à la surface de la poignée.

Selon un premier exemple, la présence d'éléments électriquement conducteurs perturbateurs dans la peinture a pour effet, par couplage capacitif entre le capteur capacitif et les éléments conducteurs, non seulement de déformer mais également d'étendre la zone de détection du capteur.

Pour le cas du capteur d'approche, on constate, habituellement, un étalement de la zone de détection d'approche à l'ensemble de la surface peinte associée à une perte de sensibilité du capteur capacitif au niveau de la zone de détection d'approche.

Pour le cas du capteur tactile, on constate une disparition complète de la fonction de détection tactile suite à la perte totale de sensibilité du capteur capacitif au niveau de la zone de détection tactile.

Selon un autre exemple, des perturbations électriques intervenues en dehors de la zone de détection peuvent être transmises à la zone de détection par la nappe conductrice recouvrant le boîtier de sorte que des contacts ou des approches réalisés en dehors de la zone de détection sont vus par le capteur et sont interprétés à tort comme des contacts ou des approches intervenus dans la zone de détection.

Ces dysfonctionnements constituent un problème que la présente invention se propose de résoudre.

A cet effet, la présente invention a pour objet un boîtier comprenant un capteur capacitif mesurant une variation de champ électrique dans un volume de détection interceptant une zone, dite zone de détection, d'une paroi extérieure dudit boîtier, ladite zone de détection ayant une délimitation déterminée, ladite paroi extérieure étant porteuse d'éléments électriquement conducteurs formant une nappe conductrice, caractérisé en ce que les éléments électriquement conducteurs sont agencés de manière que ladite nappe soit interrompue suivant une ligne fermée coïncidant sensiblement avec la délimitation de la zone de détection.

Ainsi, la présente invention consiste à créer une discontinuité dans la nappe conductrice recouvrant le capteur capacitif de manière à isoler la zone de détection.

Dans un mode de réalisation préféré, le capteur capacitif comporte une électrode de mesure située au voisinage de la paroi extérieure du boîtier et la ligne fermée se trouve au droit de la périphérie de cette électrode.

De cette manière, la ligne fermée coïncide presque exactement avec la délimitation de la zone de détection du fait que la proximité entre l'électrode de mesure et la paroi extérieure du boîtier localise la zone de détection pratiquement au droit de l'électrode de mesure.

Pour améliorer l'isolement de la zone de détection, il est également possible, selon un mode de réalisation particulier, d'interrompre la nappe conductrice suivant une seconde ligne fermée entourant la première.

Dans ce cas, la première ligne fermée délimite à proprement parler la zone de détection mais la seconde ligne fermée peut délimiter une seconde zone située autour de la zone de détection et couvrant toute la surface qu'un utilisateur est susceptible de toucher en voulant atteindre la zone de détection. A cet effet, les perturbations électriques perçues à l'intérieur de cette deuxième zone sont prises en compte par le capteur capacitif si cette seconde zone n'est pas couplée avec un plan de masse du capteur capacitif. En revanche, le reste de la nappe conductrice, à l'extérieur de la seconde zone, est couplé au plan de masse du capteur et ne générera aucune modification du champ électrique.

Dans un mode de réalisation particulier de l'invention, le boîtier comprend un second capteur capacitif qui délimite, sur la paroi extérieure, une seconde zone de détection. On isole les deux zones de détection l'une de l'autre à l'aide d'une ou plusieurs lignes fermées d'interruption de nappe, comme précédemment exposé.

A l'intérieur de la zone de détection, on peut conserver une nappe continue identique à celle présente à l'extérieur de la ligne fermée.

La ligne fermée peut alors être réalisée de différentes manières, par exemple par découpage par des moyens optiques, mécaniques, chimiques de la surface conductrice lorsque les éléments électriquement conducteurs sont des constituants de revêtements de surface tel que des peintures, des apprêts, des films ou des dépôts en couches.

Lorsque la ligne fermée est réalisée par découpage d'un revêtement de surface, la peinture du boîtier est néanmoins possible si la largeur de la ligne fermée est suffisamment réduite pour que la couche de peinture recouvre de manière continue ladite ligne fermée par capillarité.

Dans ce cas, aucune trace n'apparaît sur le boîtier peint.

On peut également former une ligne de style délimitant clairement la zone de détection pour rendre la présence de la ligne fermée de discontinuité électrique esthétiquement acceptable.

Une autre possibilité pour réaliser la discontinuité entre l'intérieur et l'extérieur de la ligne fermée est de former un maillage sur la zone de détection.

La présente invention a également pour objet une poignée d'ouvrant de véhicule automobile comprenant un boîtier tel que décrit ci-dessus, la paroi extérieure de ce boîtier constituant l'enveloppe de la poignée, qui est saisie par un utilisateur du véhicule pour manoeuvrer l'ouvrant.

Dans un mode de réalisation particulier de cette poignée, le boîtier contient un second capteur et présente une première zone de détection située vers l'extérieur de la poignée servant au verrouillage des ouvrants du véhicule ainsi qu'une seconde zone de détection située vers l'intérieur de la poignée et servant au réveil d'un système d'accès mains libres du véhicule.

Afin de faciliter la compréhension de l'invention, on va maintenant en décrire un mode de réalisation donné à titre d'exemple non limitatif, en référence aux dessins annexés dans lesquels :
- la figure 1 est une vue partielle d'une paroi extérieure d'un boîtier selon l'invention,
- la figure 2 est une section selon II-II de la figure 1,
- la figure 3 est une section analogue à la figure 2 illustrant un exemple de dysfonctionnement,
- les figures 4, 5 et 6 sont des vues analogues à la figure 1 montrant d'autres réalisations d'une zone de détection.

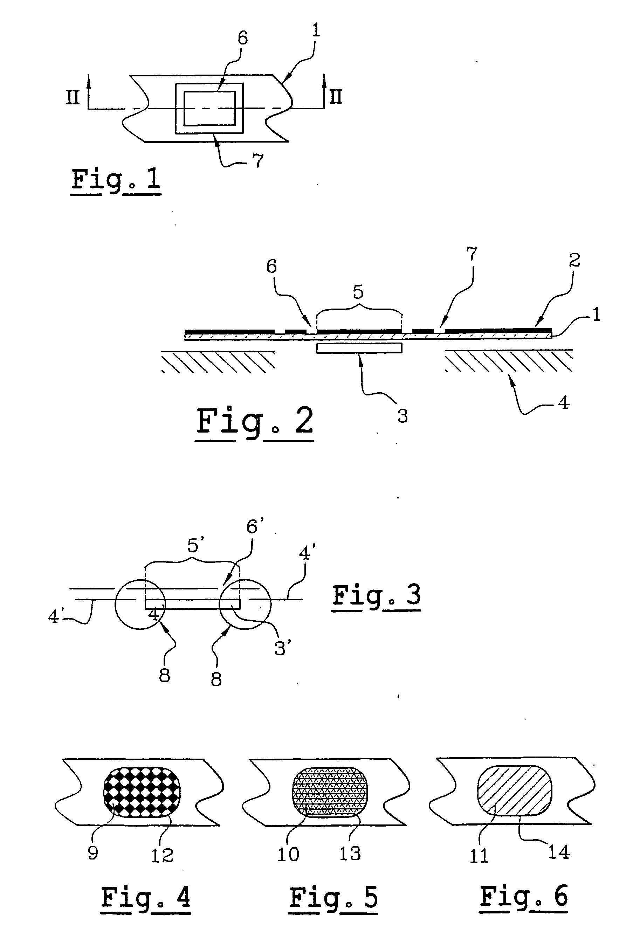

Dans l'exemple représenté aux figures 1 et 2, le boîtier comporte une paroi extérieure 1 en matière plastique, par exemple réalisée en polypropylène.

Cette paroi est recouverte d'un revêtement 2 tel qu'une peinture sur sa face extérieure, qui est celle visible sur la figure 1.

Le boîtier contient un capteur capacitif (non représenté) qui comporte deux électrodes planes : une électrode de mesure 3 et une électrode de masse 4 également désignée plan de masse, qui se trouve autour de l'électrode de mesure, dans un plan parallèle et légèrement décalé par rapport à celui de l'électrode de mesure.

L'électrode de mesure et le plan de masse sont tous deux situés à proximité de la paroi 1.

La configuration des deux électrodes est connue de l'homme du métier.

Cette configuration permet à des lignes de champs (non représentées) de balayer un volume de détection qui intercepte la paroi sur une zone de détection 5 dont la délimitation est déterminée.

Le revêtement 2 de la paroi contient des éléments conducteurs qui forment une nappe conductrice interceptant cette zone de détection.

Conformément à l'invention, cette nappe conductrice est interrompue suivant une ligne fermée 6 qui est ici conformée en rectangle coïncidant sensiblement avec la surface de l'électrode de mesure 3.

Cette ligne fermée a été obtenue, dans l'exemple décrit, par découpage de l'épaisseur de peinture.

De cette manière, d'éventuelles perturbations électriques captées par la nappe conductrice entourant l'électrode ne sont pas transmises à la zone de détection.

Dans l'exemple décrit, une seconde ligne fermée 7 entoure la première ligne fermée 6, ce qui, d'une part, améliore l'isolation de la zone de détection 5 et, d'autre part, permet d'élargir cette zone de détection de sorte que, par exemple, un contact d'un doigt d'utilisateur dans la zone comprise entre les deux lignes fermées 6 et 7 sera également perçu par le capteur capacitif.

En revanche, des contacts avec la nappe située à l'extérieur de cette seconde ligne fermée 7 ne seront pas perçus.

La figure 3 a pour objet d'illustrer le phénomène de couplage parasite qui pourrait se produire si la première ligne fermée 6' ne coïncidait pas avec l'électrode de mesure 3'.

On voit que dans les régions entourées des cercles 8, il se produit un couplage entre la zone de détection 5' et le plan de masse 4', couplage qui annule toute possibilité de détection fiable par le capteur capacitif.

Dans les exemples des figures 4, 5 et 6, la zone de détection 9, 10, 11 est réalisée par maillage selon trois géométries différentes. Ce maillage crée une discontinuité entre la zone de détection et le reste de la nappe conductrice et réalise l'isolation de la zone de détection selon une ligne fermée 12, 13, 14, conformément à l'invention.

Il est bien évident que les modes de réalisation décrit ci-dessus pourront recevoir toute modification désirable sans sortir du cadre de l'invention.

En particulier, la seconde ligne fermée 7 n'est qu'optionnelle, comme cela a déjà été indiqué.

L'invention trouve une application industrielle notamment dans la réalisation de poignées d'ouvrants de véhicules automobiles. Dans cette application, la paroi extérieure du boîtier est l'enveloppe de la poignée, enveloppe que les utilisateurs peuvent saisir pour ouvrir ou fermer l'ouvrant. Cette enveloppe est quelquefois désignée "poignée" dans le langage courant.

## Revendications

1. Boîtier de capteur capacitif muni d'une paroi extérieure (1), ledit boîtier comprenant au moins un capteur capacitif mesurant une variation de champ électrique dans un volume de détection interceptant ladite paroi extérieure (1) dudit boîtier sur une zone, dite zone de détection (5, 9, 10, 11, ladite zone de détection (5, 9, 10, 11) ayant une délimitation déterminée, ladite paroi extérieure étant porteuse d'éléments électriquement conducteurs formant une nappe conductrice, **caractérisé en ce que** les éléments électriquement conducteurs sont agencés de manière que ladite nappe soit interrompue suivant une ligne fermée (6, 7, 12, 13, 14) coïncidant sensiblement avec la délimitation de la zone de détection .

2. Boîtier selon la revendication 1, **caractérisé en ce que** le capteur capacitif comporte une électrode de mesure (3) située au voisinage de la paroi extérieure (1) du bottier et **en ce que** la ligne fermée (6) se trouve au droit de la périphérie de cette électrode.

3. Boîtier selon l'une quelconque des revendications 1 et 2, **caractérisé en ce que** la nappe conductrice est interrompue suivant une seconde ligne fermée (7) entourant la première (6).

4. Boîtier selon la revendication 3, **caractérisé en ce que** la seconde ligne fermée (7) délimite une seconde zone, située autour de la zone de détection (5) et qui n'est pas couplée avec un plan de masse du capteur capacitif.

5. Boîtier selon l'une quelconque des revendications 1 à 4, **caractérisé en ce qu'**il comprend un second capteur capacitif qui délimite, sur la paroi extérieure, une seconde zone de détection.

6. Bottier selon l'une quelconque des revendications 1 à 5, **caractérisé en ce que** les éléments électriquement conducteurs sont des constituants de revêtements de surface tel que des peintures, des apprêts, des films ou des dépôts en couches et **en ce que** la ligne fermée (6) est obtenue par découpage par des moyens optiques, mécaniques, chimiques de ce revêtement.

7. Boîtier selon la revendication 6, **caractérisé en ce que** la largeur de la ligne fermée est suffisamment réduite pour qu'une couche de peinture recouvre de manière continue ladite ligne fermée par capillarité.

8. Boîtier selon la revendication 6, **caractérisé en ce que** la paroi extérieure comporte une ligne de style délimitant clairement la zone de détection.

9. Boîtier selon l'une quelconque des revendications 1 à 5, **caractérisé en ce que** la zone de détection est recouverte d'un revêtement (9, 10, 11) qui forme un maillage.

10. Poignée d'ouvrant de véhicule automobile comprenant un boîtier selon l'une quelconque des revendications 1 à 9, la paroi extérieure de ce boîtier constituant l'enveloppe de la poignée, qui est saisie par un utilisateur du véhicule pour manoeuvrer l'ouvrant.

11. Poignée selon la revendication 10, **caractérisée en ce que** le boîtier contient un second capteur et présente une première zone de détection située vers l'extérieur de la poignée servant au verrouillage des ouvrants du véhicule ainsi qu'une seconde zone de détection située vers l'intérieur de la poignée et servant au réveil d'un système d'accès mains libres du véhicule.

12. Système d'accès mains libres pour véhicule automobile comprenant un boîtier selon l'une quelconque des revendications 1 à 9.

## Claims

1. Capacitive sensor casing provided with an outer wall (1), the said casing comprising at least one capacitive sensor measuring an electrical field variation in a detection volume intercepting the said outer wall (1) of the said casing over a zone called the detection zone (5, 9, 10, 11), the said detection zone (5, 9, 10, 11) having a predetermined boundary, the said outer wall being the bearer of electrically conductive elements forming a conductive layer, **characterized in that** the electrically conductive elements are arranged such that the said layer is interrupted along a closed line (6, 7, 12, 13, 14) substantially coinciding with the boundary of the detection zone.

2. Casing according to Claim 1, **characterized in that** the capacitive sensor comprises a measuring electrode (3) situated in the vicinity of the outer wall (1) of the casing and **in that** the closed line (6) is located perpendicular to the periphery of this electrode.

3. Casing according to any one of Claims 1 and 2, **characterized in that** the conductive layer is interrupted along a second closed line (7) surrounding the first one (6).

4. Casing according to Claim 3, **characterized in that** the second closed line (7) delimits a second zone, situated around the detection zone (5) and which is not intersected by an earth plane of the capacitive sensor.

5. Casing according to any one of Claims 1 to 4, **characterized in that** it comprises a second capacitive sensor which delimits, on the outer wall, a second detection zone.

6. Casing according to any one of Claims 1 to 5, **characterized in that** the electrically conductive elements are constituents of surface coatings such as paints, primers, films or layered deposits and **in that** the closed line (6) is obtained by cutting out this coating, using optical, mechanical or chemical means.

7. Casing according to Claim 6, **characterized in that** the width of the closed line is sufficiently small for a coat of paint to cover the said closed line continuously by capillarity.

8. Casing according to Claim 6, **characterized in that** the outer wall comprises a style line clearly delimiting the detection zone.

9. Casing according to any one of Claims 1 to 5, **characterized in that** the detection zone is covered by a coating (9, 10, 11) which forms a mesh.

10. Motor vehicle door handle comprising a casing according to any one of Claims 1 to 9, the outer wall of this casing constituting the enclosure of the handle, which is grasped by a user of the vehicle in order to manoeuvre the door.

11. Handle according to Claim 10, **characterized in that** the casing contains a second sensor and has a first detection zone situated towards the outside of the handle used for locking the doors of the vehicle and a second detection zone situated towards the inside of the handle and used for waking a hands-free access system of the vehicle.

12. Hands-free access system for a motor vehicle comprising a casing according to any one of Claims 1 to 9.

## Patentansprüche

1. Gehäuse eines kapazitiven Sensors, das mit einer Außenwand (1) versehen ist, wobei das Gehäuse mindestens einen kapazitiven Sensor enthält, der eine Änderung des elektrischen Felds in einem Erfassungsvolumen misst, das die Außenwand (1) des Gehäuses über eine Zone, Erfassungszone genannt (5, 9, 10, 11), schneidet, wobei die Erfassungszone (5, 9, 10, 11) eine bestimmte Begrenzung hat, wobei die Außenwand elektrisch leitende Elemente trägt, die eine leitende Lage bilden, **dadurch gekennzeichnet, dass** die elektrisch leitenden Elemente so angeordnet sind, dass die Lage gemäß einer geschlossenen Linie (6, 7, 12, 13, 14) unterbrochen ist, die im Wesentlichen mit der Begrenzung der Erfassungszone zusammenfällt.

2. Gehäuse nach Anspruch 1, **dadurch gekennzeichnet, dass** der kapazitive Sensor eine Messelektrode (3) aufweist, die sich in der Nähe der Außenwand (1) des Gehäuses befindet, und dass die geschlossene Linie (6) sich im rechten Winkel zum Umfang dieser Elektrode befindet.

3. Gehäuse nach einem der Ansprüche 1 und 2, **dadurch gekennzeichnet, dass** die leitende Lage gemäß einer zweiten geschlossenen Linie (7) unterbrochen ist, die die erste (6) umgibt.

4. Gehäuse nach Anspruch 3, **dadurch gekennzeichnet, dass** die zweite geschlossene Linie (7) eine zweite Zone begrenzt, die sich um die Erfassungszone (5) herum befindet und nicht mit einer Masseebene des kapazitiven Sensors gekoppelt ist.

5. Gehäuse nach einem der Ansprüche 1 bis 4, **dadurch gekennzeichnet, dass** es einen zweiten kapazitiven Sensor enthält, der auf der Außenwand eine zweite Erfassungszone begrenzt.

6. Gehäuse nach einem der Ansprüche 1 bis 5, **dadurch gekennzeichnet, dass** die elektrisch leitenden Elemente Bestandteile von Oberflächenbeschichtungen wie Lacke, Appreturen, Filme oder Ablagerungen in Schichten sind, und dass die geschlossene Linie (6) durch Durchschneiden dieser Beschichtung mittels optischer, mechanischer, chemischer Einrichtungen erhalten wird.

7. Gehäuse nach Anspruch 6, **dadurch gekennzeichnet, dass** die Breite der geschlossene Linie reduziert genug ist, damit eine Lackschicht die geschlossene Linie durch Kapillarwirkung durchgehend bedeckt.

8. Gehäuse nach Anspruch 6, **dadurch gekennzeichnet, dass** die Außenwand eine Gestaltungslinie aufweist, die die Erfassungszone klar begrenzt.

9. Gehäuse nach einem der Ansprüche 1 bis 5, **dadurch gekennzeichnet, dass** die Erfassungszone mit einer Beschichtung (9, 10, 11) bedeckt ist, die ein Maschengitter bildet.

10. Türgriff eines Kraftfahrzeugs, der ein Gehäuse nach einem der Ansprüche 1 bis 9 enthält, wobei die Außenwand dieses Gehäuses die Hülle des Griffs bildet, die von einem Benutzer des Fahrzeugs ergriffen wird, um die Tür zu betätigen.

11. Griff nach Anspruch 10, **dadurch gekennzeichnet, dass** das Gehäuse einen zweiten Sensor enthält und eine erste Erfassungszone, die sich zur Außenseite des zur Verriegelung der Türen des Fahrzeugs dienenden Griffs befindet, sowie eine zweite Erfassungszone hat, die sich zur Innenseite des Griffs befindet und zum Einschalten eines berührungslosen Zugangssystems des Fahrzeugs dient.

12. Berührungsloses Zugangssystem für ein Kraftfahrzeug, das ein Gehäuse nach einem der Ansprüche 1 bis 9 enthält.
